# EUROPEAN PATENT SPECIFICATION

(11) **EP 3 598 511 B1**
(45) Date of publication and mention of the grant of the patent: **27.01.2021**
(21) Application number: 18465548.8
(22) Date of filing: 17.07.2018
(51) Int. Cl.: H01L 35/00

(54) **POWER SOURCE FOR AN ELECTRONICAL DEVICE**
STROMQUELLE FÜR EINE ELEKTRONISCHE VORRICHTUNG
SOURCE D'ÉNERGIE POUR DISPOSITIF ÉLECTRONIQUE

(43) Date of publication of application: 22.01.2020
(73) Proprietor: Continental Automotive GmbH, 30165 Hannover (DE)
(72) Inventor: Dragan, Cristina-Mihaela, 300145 Timisoara (RO); Botusescu, Adrian, 300584 Timisoara (RO)
(74) Representative: Reuter, Andreas

(56) References cited:
- EP-A1- 3 113 238
- US-A1- 2010 207 573
- US-A1- 2014 299 169
- US-A1- 2016 050 479

## Description

The present invention is related to a secondary power source for and a method for supplying power to an electronical device, especially for a digital camera or an Advanced Driver-Assistance Systems (ADAS) camera, based on the thermoelectric effect, when a voltage of a primary power source for the electronical device drops under a predefined value.

A digital camera is a camera that captures photographs in a digital memory. Digital cameras usually have an optical system, typically using a lens with a variable diaphragm to focus light onto an image pickup device. The diaphragm and shutter admit the correct amount of light to an imager, which is a Charged-Coupled Device (CCD) or Complementary Metal-Oxide-Semiconductor (CMOS) sensor, of the digital camera. A CCD sensor has one amplifier for all the pixels, while each pixel in a CMOS active-pixel sensor has its own amplifier. Compared to CCDs, CMOS sensors use less power. Cameras with a small sensor use a Back-Side-Illuminated CMOS (BSI-CMOS) sensor. Overall final image quality is more dependent on the image processing capability of the camera, than on sensor type. The resolution of a digital camera is often limited by the image sensor that turns light into discrete signals. The brighter the image at a given point on the sensor, the larger the value that is read for that pixel. Depending on the physical structure of the sensor, a colour filter array may be used, which requires demosaicing to recreate a full-colour image. The number of pixels in the sensor determines the camera's pixel count. In a typical sensor the pixel count is the product of the number of rows and the number of columns. For example, a 1,000 by 1,000 pixel sensor would have 1,000,000 pixels or 1 megapixel. There are three main methods of capturing an image, each based on the hardware configuration of the sensor and colour filters. Single-shot capture systems use either one sensor chip with a Bayer filter mosaic, or three separate image sensors (one each for the primary additive colours: red, green and blue) which are exposed to the same image via a beam splitter (so called Three-CCD camera). Multi-shot exposes the sensor to the image in a sequence of three or more openings of the lens aperture. There are several methods of application of the multi-shot technique. The most common originally was to use a single image sensor with three filters passed in front of the sensor in sequence to obtain the additive colour information. Another multiple shot method is called Microscanning. This method uses a single sensor chip with a Bayer filter and physically moved the sensor on the focus plane of the lens to construct a higher resolution image than the native resolution of the chip. A third version combined the two methods without a Bayer filter on the chip. The third method is called scanning because the sensor moves across the focal plane much like the sensor of an image scanner. The linear or tri-linear sensors in scanning cameras utilize only a single line of photo sensors, or three lines for the three colours. Scanning may be accomplished by moving the sensor (for example, when using colour co-site sampling) or by rotating the whole camera. A digital rotating line camera offers images of very high total resolution. The choice of method for a given capture is determined largely by the subject matter. It is usually inappropriate to attempt to capture a subject that moves with anything but a single-shot system. However, the higher colour fidelity and larger file sizes and resolutions available with multi-shot and scanning methods make them attractive for commercial photographers working with stationary subjects and large-format photographs. Digital cameras can display images on a screen immediately after being recorded, and store and delete images from the digital memory. Many digital cameras can also record moving videos with or without sound. Some digital cameras can crop and stitch pictures and perform other elementary image editing.

In ADAS for vehicles digital cameras are used to gather information about different objects in the surroundings of the vehicles. The image data provided by the digital cameras are supplied to an image processing to derive the information about the objects in the surrounding of the vehicle. Thereby information like size of, distance to and speed of objects around the vehicle as well as condition of the road, weather condition, etc. is provided to the ADAS.

Digital cameras are supplied with energy by a power source like a battery. In case the voltage of the power source drops to zero, for example when the batteries supplying the digital camera are not recharged in time or when the car is turned off and therefore its power source is cut off, the digital camera may not be able to shut down its system in a controlled manner and to save current image data in a permanent memory. This may lead to loss of data or even damage to the digital camera itself.

Electronical systems can be supplied with energy by high value capacitors as secondary power source after the voltage of its primary power source (e.g. battery, etc.) has dropped to zero. However, these high value capacitors require a high volume and are therefore not practicable especially when the digital camera is used in a vehicle for an ADAS. Therefore, a small-size secondary power source for secure shutdown is needed.

In document US2010207573A1 a thermoelectric feedback circuit is disclosed which is made of a light source in thermal communication with a thermoelectric module, and a feedback circuit that directs current generated by the thermoelectric module to at least one device.

In document EP3113238A1 a power generation system is disclosed which employs a thermoelectric generator placed between an aircraft inner skin and an aircraft outer skin. The thermoelectric generator is configured to utilize a thermal differential between the inner and outer skin to generate an electric current.

Document US2016050479A1 discloses a device for providing information to a user comprising a wireless audio device capable of generating an acoustic output from signals received through a wireless communication link; and a thermoelectric generator assembly configured to provide electrical power to the wireless audio device when a portion of the thermoelectric generator assembly is disposed over or in contact with a portion of the user.

In document US2014299169A1 a power management system for an energy harvesting device is disclosed configured to provide a source voltage. The power management system may include a conditioning and control circuit configured to perform an initialization process by accumulating energy from the source voltage until an output voltage becomes regulated for a load.

The object of the present invention is to overcome or at least alleviate these problems by providing a secondary power source for an electronical device, in particular for a digital camera and especially for an ADAS camera, based on the thermoelectric effect according to independent claim 1, an electronical device comprising said secondary power source and a vehicle comprising said electronical device as well as a method for supplying power to an electronical device, in particular to a digital camera and especially to an ADAS camera, based on the thermoelectric effect according to the further independent claims. Further refinements of the present invention are subject of the dependent claims.

A secondary power source for an electronical device based on the thermoelectric effect according to the present invention comprises a thermoelectric generator, a heat sink at an ambience temperature and a power supply line. The power supply line electrically connects the thermoelectric generator with the electronical device. The thermoelectric generator is in thermal contact with the heat sink and a housing of the electronical device. The housing is in thermal contact with a circuit of the electronical device having a temperature above the ambience temperature during operation. The thermoelectric generator is configured to generate a voltage directly proportional with a temperature difference between the housing and the heat sink. The secondary power source is configured to supply electrical energy to the electronical device when a voltage of a primary power source for the electronical device drops under a predefined value.

An electronical device according to the present invention comprises a circuit having a temperature above the ambience temperature during operation, a housing and a secondary power source based on the thermoelectric effect. The housing is in thermal contact with the circuit of the electronical device. The secondary power source comprises a thermoelectric generator, a heat sink at an ambience temperature and a power supply line electrically connecting the thermoelectric generator with the electronical device. The thermoelectric generator is in thermal contact with the heat sink and the housing. The thermoelectric generator is configured to generate a voltage directly proportional with a temperature difference between the housing and the heat sink. The secondary power source is configured to supply electrical energy to the electronical device when a voltage of a primary power source for the electronical device drops under a predefined value.

A vehicle according to the present invention comprises an electronical device as described above.

A Method for supplying power to an electronical device by a secondary power source according to the present invention comprises the following steps:
Transforming thermal energy into electrical energy by a thermoelectric generator of the secondary power source. Here, the thermoelectric generator is in thermal contact with a heat sink of the secondary power source and a housing of the electronical device. Here, the thermal generator generates a voltage directly proportional with a temperature difference between the housing and the heat sink. Here, the heat sink is at an ambience temperature. Here, the housing is in thermal contact with a circuit of the electronical device having a temperature above the ambience temperature during operation. Supplying the electrical energy to the electronical device via a power supply line of the secondary power source, when a voltage of a primary power source for the electronical device drops under a predefined value. Here, the power supply line electrically connects the thermoelectric generator with the electronical device.

Both method steps may be executed sequentially or in parallel.

According to the present invention an electronical device and especially a digital camera or an Advanced Driver-Assistance Systems (ADAS) camera can be supplied with electrical energy as power by using a heat or thermal energy accumulated in the housing when a voltage of the primary power source, which supplies the electronical device with power during normal operation, drops under the predefined value e.g. to zero. The thermoelectric generator may be any element capable of the thermoelectric effect, which is the physical effect of converting heat energy in electrical energy. The heat sink may be an element with a low thermal resistance and/or a high thermal capacity. A low thermal resistance in this context is a thermal resistance of 2 K/W [Kelvin per Watt] or less A high thermal capacity in this context is a thermal capacity of equal to or more than 100 J/K [Joule per Kelvin] and preferably equal to or more than 300 J/K. The heat sink may be made from a material with a specific thermal capacity of equal to or more than 0.3 J/(g K) [Joule per Gram and per Kelvin] and preferably equal to or more than 0.5 J/(g K). The heat sink may have a weight of equal to or more than 200 g [gram]. The heat sink may be made of metal and preferably of Aluminium or Chrome or Copper or glass or iron or steel or Magnesium or Titanium or Zinc. The heat sink may also be an element of a vehicle with a high thermal capacity. The housing may cover the circuit of the electronical device and may be designed to dissipate heat, which is generated during operation of the electronical device. The housing may be made of a material with a high thermal conductivity like metal. A high thermal conductivity in this context is a thermal conductivity of 50 W/(m K) [Watt per meter and per Kelvin] or more. The thermoelectric generator is in thermal contact with the housing and the heat sink. The housing is in thermal contact with the circuit of the electronical device. These thermal contacts can be direct contacts such that direct conduction of heat between the housing and the thermoelectric generator or the thermoelectric generator and the heat sink or the housing and the circuit, respectively, occurs. The power supply line may be a cable with a conducting core and optionally an isolation around the core or a lead on a circuit board. The conducting part of the power supply line may be a material with a high electrical conductivity or low electrical resistance like copper, aluminium, gold, etc. A low electrical resistance in this context is an electrical resistance of 0.1 Ω [Ohm] or less. The power supply line is in electrical connection with the thermoelectric generator and with the electronical device. The electrical energy generated by the thermoelectric generator is supplied as power to the electrical device by the power supply line. The heat sink is at an ambience temperature. The ambience temperature is between -40 °C [degree Celsius] and +85 °C, preferably between -10 °C and +30 °C and most preferably about 20 °C. The circuit produces heat during operation. Thus, the circuit may have a temperature above the ambience temperature. The temperature of the circuit may be +60 °C or more. Especially the circuit of a digital camera or ADAS camera may generate so much heat, that an active cooling has to be provided in order to prevent overheating of the circuit. Thus, enough heat energy can be provided for the thermoelectric element to generate sufficient electrical energy to supply the digital camera/ADAS camera. The housing with high thermal conductivity may be designed to dissipate the heat from the circuit. Consequently, the temperature of the housing is approximately equal to the temperature of the circuit, which temperature is above the ambience temperature. The higher the temperature of the circuit ant thus of the housing and the lower the temperature of the ambience ant thus of the heat sink, the higher is the temperature difference that can be used by the thermoelectric generator to generate a voltage. Consequently the electrical power or voltage, respectively, generated by the thermoelectric generator is directly proportional with the temperature difference between the housing and the heat sink. Thus a sufficient temperature or overheating of the electronical device or the circuit, respectively, is necessary for the thermoelectric generator to generate sufficient electrical energy for supplying the electronical device. The thermoelectric generator may generate a voltage of equal to or more than 0.5 V [Volt], preferably of equal to or more than 1 V, more preferably of equal to or more than 2.5 V and most preferably of equal to or more than 4 V. Further the thermoelectric generator may generate a current of equal to or more than 0.1 A [Ampere], preferably of equal to or more than 0.25 A and most preferably of equal to or more than 0.4 A. The thermoelectric generator may generate a power of equal to or more than 0.8 W [Watt] and preferably of about 1 W. For example the thermoelectric generator may generate a voltage of 4V and a current of 0.25 A or a voltage of 2.5 V and 0.4 A. The secondary power source and the electronical device may be implemented on one integrated circuit board and/or as an integrated circuit or in one embedded system. The secondary power source is configured to provide electrical energy to the electronical device when the voltage of the primary power source drops under the predefined value. The predefined value can be 0.8 V or 0.5 V or 0.25 V or 0 V.

The present invention can be used in all cases where the supply with electrical energy of one electronical device is necessary for several seconds to minutes after a power down of the primary power source and the electrical device or its housing, respectively, has a sufficient overheating. Thus, the present invention allows to supply an electronic device and especially a digital camera or ADAS camera with electrical energy after the voltage of the primary power source drops underneath the predefined value necessary to sufficiently supply the electrical device/digital camera/ADAS camera long enough to have a clean shutdown of the system of the electrical device/digital camera/ADAS camera and to save needed parameters in a permanent memory as well as current (image) data in a data memory.

With the present invention in case of a sudden interruption of electrical energy supply loss of (image) data or damage to the electrical device/digital camera/ADAS camera itself can be prevented. Additionally, the present invention does not need bulky elements with high volume like high value capacitors such that a small-size secondary power source for secure shutdown is provided by the present invention. According to a refinement of the present invention the secondary power source is configured to supply electrical energy to the electronical device sufficient to shut down the electronical device.

According to the present invention the electronical device comprises the secondary power source as described above. Here, the housing has a thermal capacity that is sufficient to provide the thermoelectric generator with an amount of thermal energy sufficient to supply electrical energy to the electronical device sufficient to shut down the electronical device.

An electronical device like a digital camera or an ADAS camera needs a supply with about 0.8 W [Watt] for about less than one minute to be able to safely shut down and save all the (image) data. At an efficiency of the thermal generator of as little as 1 % [percent] a thermal energy of about 5000 J [Joule] would be sufficient to supply the digital camera/ADAS camera with electrical energy during a shut down in case of failure of the primary power source.

With the present invention loss of (image) data and damage to the electronical device can be prevented in case the primary power source fails to provide sufficient electrical energy.

According to a refinement of the present invention the thermoelectric generator is a Peltier-element.

The Peltier-element is a chemoelectric converter based on the Peltier-effect. The Peltier-effect involves the presence of heating or cooling at an electrified junction of two different conductors. The Peltier-element is able to convert, as well, heat or thermal energy into electrical energy. Thereby a temperature difference generates an electrical current according to the Seebeck-effect.

According to a refinement of the present invention the housing has a temperature of equal to or more than 40 °C above the ambience temperature.

The circuits of most electronical devices have a very high energy density and thus produce a high amount of heat. Thus the temperature of the circuit of the electronical device will reach temperatures of 60 °C to over 100 °C during operation. The housing conducts the heat away from the circuit and dissipates it. Thus the housing reaches approximately the same temperatures as the circuit and has a temperature of equal to or more than 40 °C above the ambience temperature or the temperature of the heat sink.

With a temperature difference of 40 °C between the housing and the heat sink a sufficient power supply of the electronical device and especially of a digital camera or an ADAS camera can be ensured during a shutdown.

According to a refinement of the present invention the heat sink has a thermal capacity of equal to or more than 300 J/K.

Due to the high thermal capacity, the heat sink can take up heat from the housing via the thermoelectric generator and maintain a nearly constant temperature approximately equal to the ambience temperature. The heat sink with high thermal capacity can be an element of a vehicle. The heat sink can have a thermal capacity of about the same or a higher value as the housing. The heat sink can alternatively have a low thermal resistance compared to its ambient or surroundings having a high thermal capacity.

The heat sink with a high thermal capacity ensures that the lower value of the temperature difference between the housing and the heat sink stays nearly constant and thus that a as high as possible voltage can be generated by the thermoelectric generator.

According to a refinement of the present invention the electronical device further comprises a boost converter electrically connected to the power supply line and configured to generate from a variable input voltage of the secondary power source one predefined output voltage sufficient to supply the electronical device with electrical energy.

According to a refinement of the present invention in the step of supplying the electrical energy is supplied as power to a boost converter of the electronical device via the power supply line. The method further comprises the step of: Generating from a variable input voltage of the power source one predefined output voltage sufficient to supply the electronical device with electrical energy by the boost converter.

The method steps may be executed sequentially or in parallel.

A boost converter is a DC-to-DC power converter that steps up voltage from its input to its output while stepping down current. The boost converter may consist of at least one diode, at least one transistor and at least one energy storage element like a capacitor or an inductor or a combination thereof. To reduce voltage ripple, filters made of capacitors, optionally in combination with inductors, may be added to the converter's output (so called load-side filter) and input (so called supply-side filter). For example for sufficient supply of power to a digital camera or ADAS camera a power of about 0.8 W [Watt] is sufficient during a shutdown phase of the electronical device. The predefined output voltage sufficient to supply the electronical device with energy is dependent on the type of electronical device. A common supply voltage for electronical devices is 5 V. However, most electrical devices can be sufficiently supplied with electrical energy at voltages much lower than 5 V. For example a digital camera or ADAS camera may be sufficiently supplied by the boost converter with a predefined output voltage of equal to or more than 5.5 V [Volt], preferably of equal to or more than 6.0 V and most preferably of equal to or more than 6.5 V.

The boost converter guarantees a sufficient and stable supply of power to the electronically device during a shutdown.

According to a refinement of the present invention an initial voltage of the primary power source is equal or higher than the voltage of the secondary power source or the boost converter, respectively.

Electrical devices are commonly powered by a mains supply circuit or a (rechargeable) battery or a vehicle power supply and the like or a combination thereof as primary power source. These primary power sources however may fail due to a blackout or too low charge remaining. In such case, the initial voltage of the primary power source drops below a voltage that is at least needed to sufficiently supply the electronic device with electrical energy. For example the voltage to sufficiently supply the electronic device with electrical energy can be about 5.5 V for a digital camera or an ADAS camera.

Due to the present invention failure of a primary power source can be compensated and a safe shutdown without loss of (image) data or damage to the electronical device itself can be guaranteed.

According to a refinement of the present invention the primary power source is electrically connected to a first diode and the secondary power source or the boost converter, respectively, is connected to a second diode. The two diodes are configured to avoid providing energy from the primary power source to the secondary power source and vice versa. Further, the two diodes are configured to supply the electronical device with energy from the primary power source until a voltage of the primary power source drops under a predefined value and then provide the electronical device with energy from the secondary power source.

According to a refinement of the present invention the method further comprises the steps of:
Avoiding providing electrical energy from the primary power source to the secondary power source and vice versa by two diodes. Thereby, the primary power source is electrically connected to a first diode of the two diodes and the secondary power source or the boost converter, respectively, is connected to a second diode of the two diodes.
Supplying the electronical device with energy from the primary power source until a voltage of the primary power source drops under a predefined value and then supplying the electronical device with energy from the secondary power source by the two diodes.

The method steps may be executed sequentially or in parallel.

The two diodes prevent electrical current flowing from the primary power source to the secondary power source/boost converter and also from the secondary power source/boost converter to the primary power source, depending on which voltage is higher, during normal operation of the electronical device and also in case the voltage of the primary power supply drops below the voltage to sufficiently supply the electronical circuit wit electrical power.

Thus the two diodes prevent unnecessary loss of electrical energy to either of the power sources and also possible damage to the respective power source due to overcharge or the like.

According to a refinement of the present invention the housing is made of Aluminium.

Aluminium is a material with a high thermal conductivity of over 100 W/(m K) and also a lightweight material.

Thus the housing made of Aluminium can dissipate heat from the circuit and also conduct sufficient heat to the thermoelectric element. Further, it helps to minimize the weight of the electronical device.

According to a refinement of the present invention the housing has a weight of at least 100 g [gram].

When the housing is made of at least 100 g of Aluminium it can store about 5400 J [Joule] of heat energy, when the temperature difference between the housing and the heat sink or the ambient/surroundings is about 60 °C. For example a digital camera or an ADAS camera requires about 0.8 W for a safe shutdown. If the heat energy stored in the housing is converted into electrical energy with an efficiency of as low as 1 % [percent], the supply of the digital camera/ADAS camera will be sufficient for more than one minute, which is enough time for saving (image) data and shutdown.

The housing made of at least 100 g Aluminium definitely prevents loss of (image) data and damage to the electronical device/digital camera/ADAS camera.

According to a refinement of the present invention the electronical device is a digital camera.

According to a refinement of the present invention the heat sink is an element of the vehicle.

To further reduce the needed space and weight the heat sink can be an element of the vehicle with a high thermal capacity. The Element can be a part of the body of the vehicle e.g. a mud wing, engine bonnet/hood, boot/trunk lid or the like.

According to a refinement of the present invention the electronical device is configured to provide data to an Advanced Driver-Assistance System, ADAS, of the vehicle.

Many electronical devices like digital cameras can provide information about the surroundings of or environment around the vehicle to the ADAS. The ADAS can derive necessary actions or notifications for the driver based on the provided information. A sudden failure of the primary power source can damage the electronical device and thus incorrect or unreliable information could be provided to the ADAS which could lead to false decisions or notifications. Such damaged electronic devices are thus automatically not considered in the decision making process of the ADAS and a failure notice regarding the damaged electronical device can be displayed. However, due to a damaged electronic device some features of the ADAS may have to be inactivated leading to less comfort or the like.

Due to the secondary power source and method according to the present invention damage to an electronical device of an ADAS can be prevented such that all features of the ADAS are available even after a sudden break down of the primary power source.

According to a refinement of the present invention the electronical device is an ADAS camera of the/a vehicle.

The present invention and its technical field are subsequently explained in further detail by an exemplary embodiment shown in the drawing. The exemplary embodiment only conduces better understanding of the present invention and in no case is to be construed as limiting for the scope of the present invention.
- Fig. 1:: schematically shows an ADAS camera with a secondary power source based on the thermoelectric effect according to the present invention.
- Fig. 2A: schematically shows a flow chart of a method for supplying power to an electronical device by a secondary power source.
- Fig. 2B: schematically shows a flow chart of the method including further optional steps.

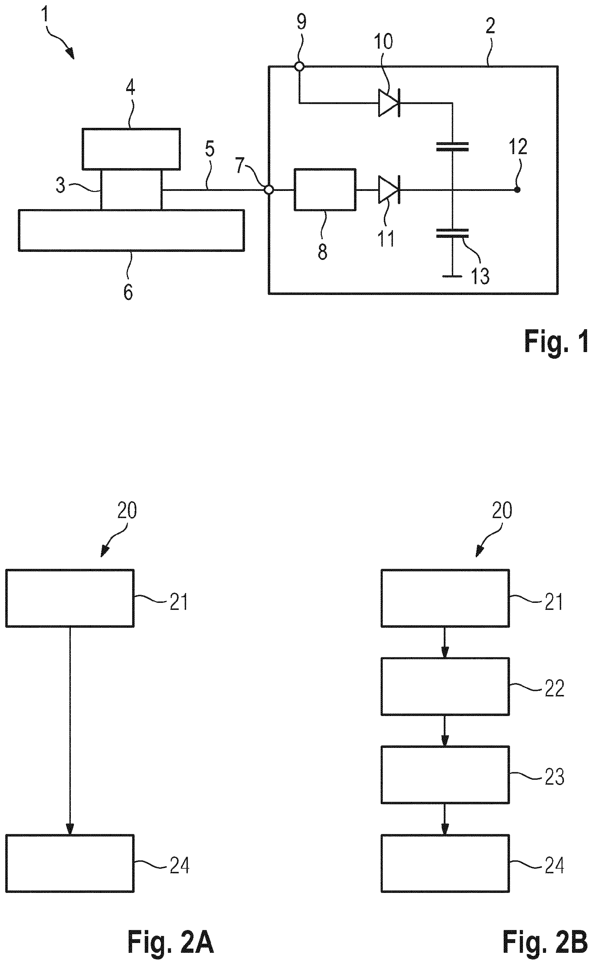

In Fig. 1 a secondary power source 1 based on the thermoelectric effect and an Advanced Driver-Assistance Systems (ADAS) camera 2 are schematically depicted.

The secondary power source 1 comprises a Peltier-element 3, a heat sink 4 and a power supply line 5. The ADAS camera 2 comprises a housing 6, a secondary input port 7, a boost converter 8 a primary input port 9, a first diode 10, a second diode 11, a power input port 12 and a power supply input capacitor 13. The ADAS camera can also comprise a primary power source (not shown).

The secondary power source 1 and the ADAS camera 2 may be part of one integrated circuit or of one embedded system.

The Peltier-element 3 is in direct thermal contact with the heat sink 4 and the housing 6 of the ADAS camera 2. The housing 6 is in direct thermal contact with a circuit (not depicted) of the ADAS camera 2. The heat sink 4 is part of a body of a vehicle at which the ADAS camera is installed. The heat sink 4 is made of steel or Aluminium with a specific thermal capacity of 0.466 J/(g K) [Joule per gram and per Kelvin] or 0.897 J/(g K), respectively, and a total weight of 200 g [gram] or more. Thus, the heat sink 4 has a thermal capacity of at least 5400 J [Joule] at 60 °C [degree Celsius] temperature difference the heat sink 4 and the ambient/surroundings. The heat sink 4 has a temperature of about an ambience temperature which is about -15 °C to +35 °C. Due to the thermal capacity of the heat sink 4 it remains nearly constant in temperature even if heat is conducted from the housing 6 via the Peltier-element 3 to the heat sink 4. The circuit of the ADAS camera generates heat during operation. The housing 6 is made of Aluminium with a thermal conductivity of 167 W/(m K) [Watt per meter and per Kelvin], a specific thermal capacity of 0.897 J/(g K) and is designed to drain heat from the circuit and to dissipate it. Here the heat sink 4 can be an element of a vehicle, at which the ADAS camera is installed. The housing 6 has a weight of 100 g and can store more than 5400 J [Joule] of heat (thermal energy). The circuit has a temperature of about 60 °C during operation and thus a temperature of about 25 °C to 75°C above the ambience temperature. The Peltier-element 3 generates a voltage directly proportional to this temperature difference between the housing 6 and the heat sink 4. The voltage generated by the Peltier-element 3 is about 2 V [Volt] to 4 V.

The power supply line 5 may be a cable or a lead on a circuit board of the integrated circuit or of the embedded system. The power supply line 5 electrically connects the Peltier-element 3 with the secondary input port 7 of the ADAS camera 2. The voltage supplied by the Peltier-element 3 of the power source 1 is fed to the boost converter 8. The boost converter 8 is a DC-to-DC power converter that steps up the voltage from the Peltier-element 2 at its input to a higher voltage at its output while stepping down current. The higher voltage at the output of the boost converter 8 is about 6.5 V.

At the primary input port 9 a vehicle power supply is electrically connected as the primary power source. During normal operation the ADAS camera 2 is supplied with electrical energy by the primary power source. The secondary power source 1 is designed and configured for supplying the ADAS camera 2 with electrical energy in case the voltage of the primary power source drops to zero or under a predefined value defining a level needed to sufficiently supply the ADAS camera 2. The primary input port 9 is electrically connected to the first diode 10 and the output of the boost converter 8 is connected to the second diode 11. The two diodes 10, 11 prevent electrical energy flowing from the primary power source to the secondary power source 1 and vice versa. Both the diodes 10, 11 are electrically connected with the power input port 12 of the ADAS camera 2 such that the circuit of the ADAS camera 2 is provided with electrical energy either from the primary power source/vehicle power supply during normal operation or from the secondary power source 1 in case the voltage of the primary power source breaks down to a value insufficient to supply the ADAS camera with power. The two diodes 10, 11 are further electrically connected to the power supply input capacitor 13. The power supply input capacitor 13 smoothes the voltage provided by the primary power source via the first diode 10 and by the boost converter 8 via the second diode 11.

The secondary power source 1 guarantees supply of electrical energy to the ADAS camera 2 in case the supply from the primary power source fails such that a safe shutdown without loss of (image) data or damage to the ADAS camera and especially to its circuit can be guaranteed.

The described secondary power source 1 of Fig. 1 may also be used for other electronical devices and is not limited to ADAS cameras.

In Fig. 2A a flow chart of s method 20 for supplying power to an electronical device by a secondary power source is schematically depicted. Fig. 2B depicts two additional steps that can be optionally implemented. Step S1 is a step of transforming 21 thermal energy into electrical energy by a thermoelectric generator of the secondary power source. The thermoelectric generator is a Peltier-element, which is in thermal contact with a heat sink of the secondary power source and a housing of the electronical device. The Peltier-element is generating a voltage directly proportional with a temperature difference between the housing and the heat sink. Here, the heat sink is at an ambience temperature. The housing is in thermal contact with a circuit of the electronical device having a temperature above the ambience temperature during operation. Step S2 is an optional step of generating 22 from a variable input voltage of the secondary power source one predefined output voltage sufficient to supply the electronical device with energy by a boost converter of the electronical device. Step S3 is an optional step of avoiding 23 providing electrical energy from a primary power source for the electronical device to the secondary power source and vice versa by two diodes. Here, the primary power source is electrically connected to a first diode of the two diodes and the secondary power source or the boost converter, respectively, is connected to a second diode of the two diodes. Step S4 is a step of supplying 24 the electrical energy to the electronical device via a power supply line of the secondary power source electrically connecting the thermoelectric generator with the electronical device, when a voltage of a primary power source for the electronical device drops under a predefined value. The electrical energy from the primary power source is provided to the electronical device until the voltage of the primary power source drops under the predefined value. Then the electronical device is supplied with electrical energy from the secondary power source by the two diodes.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

In the foregoing detailed description, various features are grouped together in one or more examples or examples for the purpose of streamlining the disclosure. It is understood that the above description is intended to be illustrative, and not restrictive. It is intended to cover all alternatives, modifications and equivalents as may be included within the scope of the invention. Many other examples will be apparent to one skilled in the art upon reviewing the above specification.

Specific nomenclature used in the foregoing specification is used to provide a thorough understanding of the invention. However, it will be apparent to one skilled in the art in light of the specification provided herein that the specific details are not required in order to practice the invention. Thus, the foregoing descriptions of specific embodiments of the present invention are presented for purposes of illustration and description. They are not intended to be exhaustive or to limit the invention to the precise forms disclosed; obviously many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated. Throughout the specification, the terms "including" and "in which" are used as the plain-English equivalents of the respective terms "comprising" and "wherein," respectively. Moreover, the terms "first," "second," and "third," etc., are used merely as labels, and are not intended to impose numerical requirements on or to establish a certain ranking of importance of their objects. In the context of the present description and claims the conjunction "or" is to be understood as including ("and/or") and not exclusive ("either ... or") .

### REFERENCE SIGNS

- 1: (secondary) power source
- 2: Advanced Driver-Assistance Systems (ADAS) camera
- 3: Peltier-element
- 4: heat sink
- 5: power line
- 6: housing
- 7: secondary input port
- 8: boost converter
- 9: primary input port
- 10: first diode
- 11: second diode
- 12: power input port
- 13: power supply input capacitor
- 20: method
- 21: Step S1
- 22: Step S2
- 23: Step S3
- 24: Step S4

## Claims

1. Electronical device (2) and secondary power source (1) for the electronical device (2) based on the thermoelectric effect, the secondary power source comprising:
a thermoelectric generator (3),
a heat sink (4) at an ambience temperature and
a power supply line (5) electrically connecting the thermoelectric generator (3) with the electronical device (2),
wherein the thermoelectric generator (3) is in thermal contact with the heat sink (4) and a housing (6) of the electronical device (2), which housing (6) is in thermal contact with a circuit of the electronical device (2) having a temperature above the ambience temperature during operation,
wherein the thermoelectric generator (3) is configured to generate a voltage directly proportional with a temperature difference between the housing (6) and the heat sink (4) and wherein the secondary power source (1) is configured to supply electrical energy to the electronical device (2) when a voltage of a primary power source for the electronical device (2) drops under a predefined value.

2. Electronical device (2) and secondary power source (1) according to claim 1, wherein the secondary power source (1) is configured to supply electrical energy to the electronical device (2) sufficient to shut down the electronical device (2).

3. Electronical device (2) and secondary power source (1) according to any preceding claim, wherein the thermoelectric generator is a Peltier-element (3).

4. Electronical device (2) and secondary power source (1) according to any preceding claim, wherein the housing (6) has a temperature of equal to or more than 40 °C [degree Celsius] above the ambience temperature.

5. Electronical device (2) and secondary power source (1) according to any preceding claim, wherein the housing (6) has a thermal capacity that is sufficient to provide the thermoelectric generator (3) with an amount of thermal energy sufficient to supply electrical energy to the electronical device (2) sufficient to shut down the electronical device (2).

6. Electronical device (2) and secondary power source (1) according to any preceding claim, wherein the electronical device (2) further comprises a boost converter (8) electrically connected to the power supply line (5) and configured to generate from a variable input voltage of the secondary power source (1) one predefined output voltage sufficient to supply the electronical device (2) with electrical energy.

7. Electronical device (2) and secondary power source (1) according to any preceding claim, wherein the primary power source is electrically connected to a first diode (10) and the secondary power source (1) or the boost converter (8), respectively, is connected to a second diode (11), wherein the two diodes (10, 11) are configured to avoid providing electrical energy from the primary power source to the secondary power source (1) and vice versa and
wherein the two diodes (10, 11) are configured to supply the electronical device (2) with electrical energy from the primary power source until the voltage of the primary power source drops under the predefined value and then provide the electronical device (2) with electrical energy from the secondary power source (1).

8. Vehicle comprising an electronical device (2) and a secondary power source (1) according to any preceding claim.

9. Vehicle according to claim 8 wherein the heat sink (4) is an element of the vehicle.

10. Method (20) for supplying power to an electronical device (2) by a secondary power source (1), the electronical device (2) and the secondary power (1) being according to claim 1, comprising the steps of:
- transforming (21) thermal energy into electrical energy by a thermoelectric generator (3) of the secondary power source (1) being in thermal contact with a heat sink (4) of the secondary power source and a housing (6) of the electronical device (2) and generating a voltage directly proportional with a temperature difference between the housing (6) and the heat sink (4), wherein the heat sink (4) is at an ambience temperature and wherein the housing (6) is in thermal contact with a circuit of the electronical device (2) having a temperature above the ambience temperature during operation and
- supplying (24) the electrical energy to the electronical device (2) via a power supply line (5) of the secondary power source (1) electrically connecting the thermoelectric generator (3) with the electronical device(2), when a voltage of a primary power source for the electronical device (2) drops under a predefined value.

## Patentansprüche

1. Elektronische Vorrichtung (2) und sekundäre Stromquelle (1) für die elektronische Vorrichtung (2), die auf dem thermoelektrischen Effekt basiert, wobei die sekundäre Stromquelle umfasst:
einen thermoelektrischen Generator (3),
eine Wärmesenke (4) mit einer Umgebungstemperatur und eine Stromversorgungsleitung (5), die den thermoelektrischen Generator (3) elektrisch mit der elektronischen Vorrichtung (2) verbindet,
wobei der thermoelektrische Generator (3) in thermischem Kontakt mit der Wärmesenke (4) und einem Gehäuse (6) der elektronischen Vorrichtung (2) steht, wobei das Gehäuse (6) in thermischem Kontakt mit einer Schaltung der elektronischen Vorrichtung (2) steht, die bei Betrieb eine Temperatur über der Umgebungstemperatur aufweist,
wobei der thermoelektrische Generator (3) dazu ausgestaltet ist, eine Spannung zu erzeugen, die direkt proportional zu einem Temperaturunterschied zwischen dem Gehäuse (6) und der Wärmesenke (4) ist, und wobei die sekundäre Stromquelle (1) dazu ausgestaltet ist, der elektronischen Vorrichtung (2) elektrische Energie zuzuführen, wenn eine Spannung einer primären Stromquelle für die elektronische Vorrichtung (2) unter einen vorab definierten Wert fällt.

2. Elektronische Vorrichtung (2) und sekundäre Stromquelle (1) nach Anspruch 1, wobei die sekundäre Stromquelle (1) dazu ausgestaltet ist, der elektronischen Vorrichtung (2) elektrische Energie zuzuführen, die ausreichend ist, um die elektronische Vorrichtung (2) außer Betrieb zu nehmen.

3. Elektronische Vorrichtung (2) und sekundäre Stromquelle (1) nach einem vorangehenden Anspruch,
wobei der thermoelektrische Generator ein Peltier-Element (3) ist.

4. Elektronische Vorrichtung (2) und sekundäre Stromquelle (1) nach einem vorangehenden Anspruch,
wobei das Gehäuse (6) eine Temperatur von gleich oder mehr als 40 °C [Grad Celsius] über der Umgebungstemperatur aufweist.

5. Elektronische Vorrichtung (2) und sekundäre Stromquelle (1) nach einem vorangehenden Anspruch,
wobei das Gehäuse (6) eine Wärmekapazität aufweist, die ausreichend ist, um den thermoelektrischen Generator (3) mit einer Menge an Wärmeenergie zu versorgen, die ausreichend ist, um der elektronischen Vorrichtung (2) elektrische Energie zuzuführen, die ausreichend ist, um die elektronische Vorrichtung (2) außer Betrieb zu nehmen.

6. Elektronische Vorrichtung (2) und sekundäre Stromquelle (1) nach einem vorangehenden Anspruch,
wobei die elektronische Vorrichtung (2) ferner einen Aufwärtswandler (8) umfasst, der elektrisch mit der Stromversorgungsleitung (5) verbunden ist und dazu ausgestaltet ist, aus einer veränderlichen Eingangsspannung der sekundären Stromquelle (1) eine vorab definierte Ausgangsspannung zu erzeugen, die ausreichend ist, um die elektronische Vorrichtung (2) mit elektrischer Energie zu versorgen.

7. Elektronische Vorrichtung (2) und sekundäre Stromquelle (1) nach einem vorangehenden Anspruch,
wobei die primäre Stromquelle elektrisch mit einer ersten Diode (10) verbunden ist und die sekundäre Stromquelle (1) bzw. der Aufwärtswandler mit einer zweiten Diode (11) verbunden ist, wobei die zwei Dioden (10, 11) dazu ausgestaltet sind, eine Bereitstellung elektrischer Energie von der primären Stromquelle an die sekundäre Stromquelle (1) und umgekehrt zu verhindern, und
wobei die zwei Dioden (10, 11) dazu ausgestaltet sind, die elektronische Vorrichtung (2) mit elektrischer Energie aus der primären Stromquelle zu versorgen, bis die Spannung der primären Stromquelle unter den vorab definierten Wert fällt, und dann die elektronische Vorrichtung (2) mit elektrischer Energie aus der sekundären Stromquelle (1) zu versorgen.

8. Fahrzeug, das eine elektronische Vorrichtung (2) und eine sekundäre Stromquelle (1) nach einem vorangehenden Anspruch umfasst.

9. Fahrzeug nach Anspruch 8, wobei die Wärmesenke (4) ein Element des Fahrzeugs ist.

10. Verfahren (20) zum Zuführen von Strom zu einer elektronischen Vorrichtung (2) durch eine sekundäre Stromquelle (1), wobei die elektronische Vorrichtung (2) und die sekundäre Stromquelle (1) Anspruch 1 entsprechen, folgende Schritte umfassend:
- Umwandeln (21) von Wärmeenergie in elektrische Energie durch einen thermoelektrischen Generator (3) der sekundären Stromquelle (1), der in thermischem Kontakt mit einer Wärmesenke (4) der sekundären Stromquelle und einem Gehäuse (6) der elektronischen Vorrichtung (2) steht, und Erzeugen einer Spannung, die direkt proportional zu einem Temperaturunterschied zwischen dem Gehäuse (6) und der Wärmesenke (4) ist, wobei die Wärmesenke (4) eine Umgebungstemperatur aufweist und wobei das Gehäuse (6) in thermischem Kontakt mit einer Schaltung der elektronischen Vorrichtung (2) steht, die bei Betrieb eine Temperatur über der Umgebungstemperatur aufweist, und
- Zuführen (24) der elektrischen Energie zu der elektronischen Vorrichtung (2) über eine Stromversorgungsleitung (5) der sekundären Stromquelle (1), die den thermoelektrischen Generator (3) elektrisch mit der elektronischen Vorrichtung (2) verbindet, wenn eine Spannung einer primären Stromquelle für die elektronische Vorrichtung (2) unter einen vorab definierten Wert fällt.

## Revendications

1. Dispositif électronique (2) et source d'énergie secondaire (1) pour le dispositif électronique (2) basé sur l'effet thermoélectrique, la source d'énergie secondaire comprenant :
un générateur thermoélectrique (3),
un dissipateur thermique (4) à une température ambiante et une ligne d'alimentation électrique (5) connectant électriquement le générateur thermoélectrique (3) avec le dispositif électronique (2),
le générateur thermoélectrique (3) étant en contact thermique avec le dissipateur thermique (4) et un boîtier (6) du dispositif électronique (2), lequel boîtier (6) est en contact thermique avec un circuit du dispositif électronique (2) ayant une température supérieure à la température ambiante pendant le fonctionnement,
le générateur thermique (3) étant conçu pour générer une tension directement proportionnelle avec une différence de température entre le boîtier (6) et le dissipateur thermique (4) et la source d'énergie secondaire (1) étant conçue pour alimenter le dispositif électronique (2) avec une énergie électrique lorsqu'une tension d'une source d'énergie primaire pour le dispositif électronique (2) passe sous une valeur prédéfinie.

2. Dispositif électronique (2) et source d'énergie secondaire (1) selon la revendication 1, la source d'énergie secondaire (1) étant conçue pour alimenter le dispositif électronique (2) avec une énergie électrique suffisante pour arrêter le dispositif électronique (2).

3. Dispositif électronique (2) et source d'énergie secondaire (1) selon l'une quelconque des revendications précédentes,
le générateur thermoélectrique étant un élément Peltier (3).

4. Dispositif électronique (2) et source d'énergie secondaire (1) selon l'une quelconque des revendications précédentes,
le boîtier (6) ayant une température supérieure ou égale à 40 °C [degrés Celsius] au-dessus de la température ambiante.

5. Dispositif électronique (2) et source d'énergie secondaire (1) selon l'une quelconque revendication précédente,
le boîtier (6) ayant une capacité thermique qui est suffisante pour fournir au générateur thermoélectrique (3) une quantité d'énergie thermique suffisante pour alimenter le dispositif électronique (2) avec une énergie électrique suffisante pour arrêter le dispositif électronique (2).

6. Dispositif électronique (2) et source d'énergie secondaire (1) selon l'une quelconque revendication précédente,
le dispositif électronique (2) comprenant en outre un convertisseur élévateur (8) connecté électriquement à la ligne d'alimentation électrique (5) et conçu pour générer une tension de sortie prédéfinie suffisante pour alimenter en énergie électrique le dispositif électronique (2), à partir d'une tension d'entrée variable de la source d'énergie secondaire (1).

7. Dispositif électronique (2) et source d'énergie secondaire (1) selon l'une quelconque revendication précédente,
la source d'énergie primaire étant connectée électriquement à une première diode (10) et la source d'énergie secondaire (1) ou le convertisseur élévateur (8), respectivement, étant connectée à une deuxième diode (11), les deux diodes (10, 11) étant conçues pour éviter de fournir de l'énergie électrique de la source d'énergie primaire à la source d'énergie secondaire (1) et inversement, et
les deux diodes (10, 11) étant conçues pour alimenter en énergie électrique le dispositif électronique (2) à partir de la source d'énergie primaire jusqu'à ce que la tension de la source d'énergie primaire passe sous la valeur prédéfinie, puis pour alimenter en énergie électrique le dispositif électronique (2) à partir de la source d'énergie secondaire (1).

8. Véhicule comprenant un dispositif électronique (2) et une source d'énergie secondaire (1) selon l'une quelconque revendication précédente.

9. Véhicule selon la revendication 8, le dissipateur thermique (4) étant un élément du véhicule.

10. Procédé (20) pour alimenter en énergie un dispositif électronique (2) à l'aide d'une source d'énergie secondaire (1), le dispositif électronique (2) et la source d'énergie secondaire (1) étant conformes la revendication 1,
comprenant les étapes de :
- transformer (21) de l'énergie thermique en énergie électrique à l'aide d'un générateur thermoélectrique (3) de la source d'énergie secondaire (1), lequel est en contact thermique avec un dissipateur thermique (4) de la source d'énergie secondaire et un boîtier (6) du dispositif électronique (2), et générer une tension directement proportionnelle avec une différence de température entre le boîtier (6) et le dissipateur thermique (4), le dissipateur thermique (4) étant à une température ambiante et le boîtier (6) étant en contact thermique avec un circuit du dispositif électronique (2) ayant une température supérieure à la température ambiante pendant le fonctionnement, et
- alimenter (24) en énergie électrique le dispositif électronique (2) via une ligne d'alimentation électrique (5) de la source d'énergie secondaire (1) connectant électriquement le générateur thermoélectrique (3) avec le dispositif électronique (2), lorsqu'une tension d'une source d'énergie primaire pour le dispositif électronique (2) passe sous une valeur prédéfinie.
